**Europäisches Patentamt**

**European Patent Office**

**Office européen des brevets**

(19)

(11) Veröffentlichungsnummer: **0 104 616**

**A2**

# (12) EUROPÄISCHE PATENTANMELDUNG

(21) Anmeldenummer: **83109453.7**

(22) Anmeldetag: **22.09.83**

(51) Int. Cl.³: **H 01 L 27/10**
**G 11 C 11/40**

(30) Priorität: **28.09.82 DE 3235880**

(43) Veröffentlichungstag der Anmeldung:
**04.04.84 Patentblatt 84/14**

(84) Benannte Vertragsstaaten:
**AT DE FR GB IT**

(71) Anmelder: **SIEMENS AKTIENGESELLSCHAFT**
**Berlin und München Wittelsbacherplatz 2**
**D-8000 München 2(DE)**

(72) Erfinder: **Wieder, Armin, Dr.**
**Zentnerstrasse 20**
**D-8000 München 40(DE)**

(54) **Statische Speicherzelle in Zwei-Kanal-Technik.**

(57) Speicherzelle, bei der zwei auf einem Halbleiterkörper angeordnete Schalttransistoren eines ersten Kanaltyps (T1, T2) über jeweils ein Lastelement des zweiten Kanaltyps (T3, T4) an eine Versorgungsspannung geschaltet sind, wobei die Schaltungsknoten (3, 4) den Drainanschlüssen der Schalttransistoren (T1, T2) entsprechen und mit dem Gate des jeweils anderen Schalttransistors sowie mit dem Gate des zu diesem in Serie liegenden Lastelements verbunden sind. Angestrebt wird eine flächensparende Ausbildung der Speicherzelle. Das wird dadurch erreicht, daß jedes der Lastelemente aus stark dotierten Abschnitten einer isoliert auf dem Halbleiterkörper aufgebrachten Schicht aus polykristallinem Silizium besteht, sowie aus einem zwischen diesen Abschnitten liegenden, schwach dotierten oder undotierten Teil der Schicht, der ein Kanalgebiet bildet. Unterhalb des letzteren befindet sich ein umdotiertes Gebiet des Halbleiterkörpers, das als Gategebiet dient. Der Anwendungsbereich umfaßt Speicherzellen für VLSI-Applikationen.

## FIG 1

EP 0 104 616 A2

0104616

SIEMENS AKTIENGESELLSCHAFT     Unser Zeichen

Berlin und München            VPA   82 P 1 8 9 7 E

Statische Speicherzelle in Zwei-Kanal-Technik

Die Erfindung bezieht sich auf eine statische Speicherzelle in Zwei-Kanal-Technik nach dem Oberbegriff des
Patentanspruchs 1.

Bekannte Speicherzellen dieser Art sind in CMOS-Technik
aufgebaut. Dabei werden üblicherweise n-Kanal-Schalttransistoren und p-Kanal-Lastelemente an der Grenzfläche eines p-dotierten Halbleiterkörpers angeordnet,
wobei die Source- und Draingebiete der Lastelemente in
einem n-dotierten, wannenförmigen Halbleitergebiet liegen,
das in den p-dotierten Halbleiterkörper eingefügt ist.
Eine solche Realisierung einer statischen Zwei-Kanal-
Speicherzelle erfordert aber wegen des wannenförmigen
Halbleitergebietes eine relativ große Halbleiterfläche.

Der Erfindung liegt die Aufgabe zugrunde, eine statische
Speicherzelle der eingangs angedeuteten Art auf einer
kleineren Halbleiterfläche zu realisieren, als das bei
dem genannten herkömmlichen Zellenaufbau möglich ist.
Das wird erfindungsgemäß durch eine Ausbildung der
Speicherzelle nach dem kennzeichnenden Teil des Patentanspruchs 1 erreicht.

Der mit der Erfindung erzielbare Vorteil besteht insbesondere darin, daß die als Isolierschicht-Feldeffekttransistoren des zweiten Kanaltyps ausgebildeten Lastelemente in der Ebene der auf dem Halbleiterkörper isoliert
aufgebrachten polykristallinen Siliziumschicht liegen,

St 1 Hub / 27.09.1982

so daß das bei Zwei-Kanal-Ausführungen bisher notwendige wannenförmige Halbleitergebiet entfällt. Die von den Potentialen der Schaltungsknoten her erfolgende Steuerung der Lastelemente erfolgt über die unmittelbar unterhalb der Kanalgebiete der Lastelemente angeordneten Teilgebiete des Halbleiterkörpers, so daß hierfür keine zusätzliche Halbleiterfläche aufgewendet werden muß. Daher ergibt sich für die Halbleiterzelle ein so geringer Flächenbedarf, daß bei einer Vielzahl von auf einem Halbleiterkörper angeordneten Speicherzellen dieser Art eine hohe Packungsdichte gewährleistet ist.

Die Patentansprüche 2 bis 8 sind auf bevorzugte Ausgestaltungen und Weiterbildungen der Erfindung gerichtet.

Die Erfindung wird nachfolgend anhand der Zeichnung näher erläutert. Dabei zeigt:

Fig. 1    das Prinzipschaltbild einer statischen Speicherzelle in Zwei-Kanal-Technik,

Fig. 2    den Querschnitt eines nach der Erfindung ausgebildeten Lastelements,

Fig. 3    den Entwurf einer erfindungsgemäßen Speicherzelle und

Fig. 4    einen Querschnitt durch einen Teil der Anordnung nach Fig. 3.

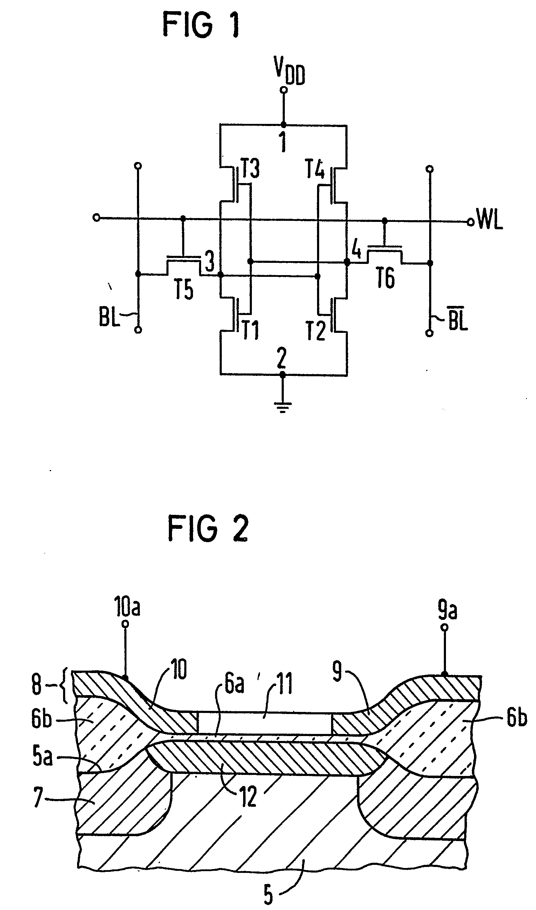

Fig. 1 zeigt das Prinzipschaltbild einer herkömmlichen statischen Speicherzelle in Zwei-Kanal-Technik. Dabei sind zwei Schalttransistoren T1 und T2 vorgesehen, die z. B. als n-Kanal-Feldeffekttransistoren ausgebildet sind. In Serie zu T1 liegt ein p-Kanal-Lastelement T3, das durch einen Feldeffekttransistor gebildet wird. Analog hierzu liegt ein zweites p-Kanal-Lastelement T4 in Form eines Feldeffekttransistors in Serie zu T2. Die Sourceanschlüsse von T3 und T4 sind an einen Schaltungspunkt 1

0104616

gelegt, der mit einer Versorgungsspannung $V_{DD}$ beschaltet ist, während die Sourceanschlüsse von T1 und T2 an einen Schaltungspunkt 2 geführt sind, der mit dem Bezugspotential beschaltet ist. Der Drainanschluß von T1 bildet einen Schaltungsknoten 3, der mit dem Gate des Lastelements T4 und mit dem Gate des Schalttransistors T2 verbunden ist. Andererseits bildet der Drainanschluß von T2 einen Schaltungsknoten 4, der mit dem Gate des Lastelements T3 und dem Gate des Schalttransistors T1 verbunden ist. Der Schaltungsknoten 3 ist über einen Auswahltransistor T5 an eine Bitleitung BL geführt, während der Schaltungsknoten 4 über einen Auswahltransistor T6 mit einer zweiten Bitleitung $\overline{BL}$ verbunden ist. Die Gateelektroden des Auswahltransistoren T5 und T6 sind an eine Wortleitung WL geschaltet.

Fig. 2 zeigt den Querschnitt eines nach der Erfindung ausgebildeten Lastelements, das den Transistoren T3 oder T4 von Fig. 1 entspricht. Dabei bezeichnet 5 einen Körper aus dotiertem Halbleitermaterial, z. B. p-dotiertem Silizium, der mit einer elektrisch islierenden Schicht abgedeckt ist, die aus einem Dünnschichtbereich 6a und Dickschichtbereichen 6b besteht. Unter der Annahme, daß die elektrisch isolierende Schicht aus $SiO_2$ besteht, werden die Bereiche 6a im folgenden als Gateoxidbereiche und die Bereiche 6b als Feldoxidbereiche bezeichnet. Unterhalb jedes Feldoxidbereiches 6b befindet sich an der Grenzfläche 5a des Halbleiterkörpers 5 eine Feldimplantation 7, d. h. ein Halbleitergebiet, das mit einer die Grunddotierung von 5 verstärkenden Zusatzdotierung versehen ist.

Auf der Schicht 6a, 6b ist eine Schicht 8 aus polykristallinem Silizium aufgebracht, die zwei über den Feldoxidbereichen 6b liegende Abschnitte 9 und 10 aufweist, die

$p^+$-dotiert sind. Sie haben z. B. eine Störstellenkonzen-tration von wenigstens $10^{18}$ pro $cm^3$. Zwischen den Ab-schnitten 9 und 10 liegt ein Gebiet 11 der polykristallinen Schicht 8, das undotiert oder schwach p-dotiert ist, worunter beispielsweise eine Störstellenkonzentration von $10^{15}$ pro $cm^3$ verstanden wird. Unterhalb von 11 befindet sich ein $n^+$-dotiertes Gebiet 12 im p-dotierten Körper 5, das z. B. eine Störstellenkonzentration von $10^{19}$ pro $cm^3$ aufweist. Die Abschnitte 9 und 10 bilden jeweils das Sourcegebiet und das Draingebiet des Lastelements, zwischen denen das p-Kanalgebiet 11 liegt. Bei Zuführung einer positiven Spannung $V_{DD}$ über einen Anschluß 9a und bei Anschaltung des Bezugspotentials über einen Anschluß 10a, fließt im Kanalgebiet 11 ein Strom. Durch eine positive Spannung, die dem Gategebiet 12 zugeführt wird, entsteht jedoch eine Einschnürung des Querschnitts des Kanalgebiets 11, wobei sich der Bahnwiderstand, den der genannte Strom vorfindet, mit ansteigender Spannung am Gategebiet stark vergrößert.

Gemäß Fig. 1 ist das Sourcegebiet 9 eines Lastelements nach Fig. 2, das als Element T3 eingesetzt wird, über einen Anschluß 1 mit der Versorgungsspannung $V_{DD}$ beschaltet, während das Draingebiet 10 mit dem Schaltungsknoten 3 beschaltet ist. Das Gategebiet 12 liegt gemäß Fig. 1 am anderen Schaltungsknoten 4, der in Abhängigkeit vom Speicherzustand der Zelle mit einer Spannung zwischen 0 V und $V_{DD}$ beaufschlagt ist.

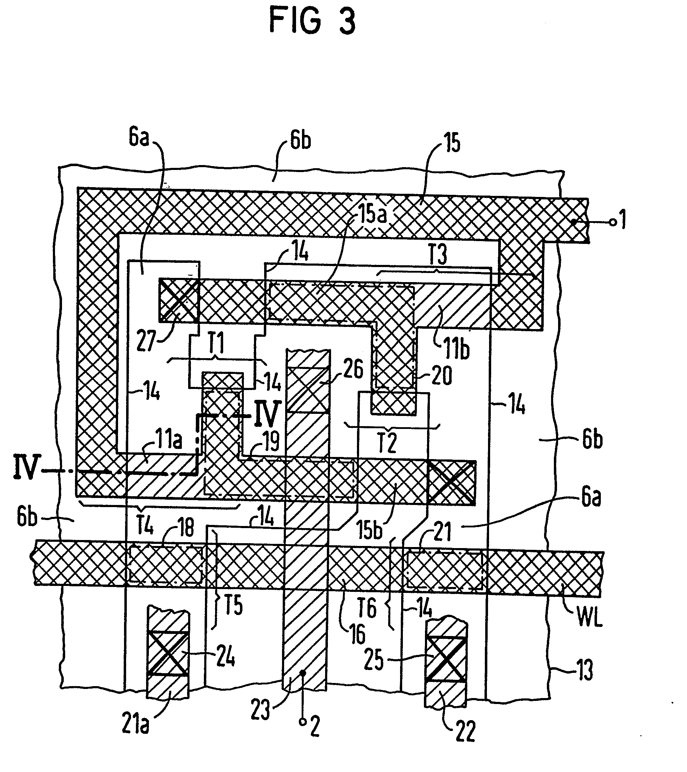

Fig. 3 zeigt einen durch die Linie 13 begrenzten Teil des Halbleiterkörpers 5 (Fig. 2), auf dem die gesamte Speicherzelle nach Fig. 1 aufgebaut ist. Die Grenzfläche 5a ist mit Feldoxidbereichen 6b und Gateoxidbereichen 6a abgedeckt, wobei die Grenzen zwischen 6a und 6b längs der Linien 14 verlaufen. Zwischen den Linien 14 befindet sich ein etwa mäanderförmiger Gateoxidbereich 6a. Dieser ist in Fig. 3 oben, links und rechts von einem rahmenartigen Feldoxidbereich 6b umgeben. Auf den Bereichen 6a und 6b sind streifenförmige Strukturen aus hochdotiertem, polykristallinem Silizium angeordnet, die zur besseren Übersicht doppelt schraffiert dargestellt sind. Dabei verläuft ein erster Streifen 15 im oberen Teil der Fig. 3 von links nach rechts, deckt Teile der in vertikaler Richtung verlaufenden Feldoxidbereiche 6b ab und ist mit horizontalen Abzweigungen 15a und 15b versehen. Ein zweiter Streifen 16 aus polykristallinem Silizium verläuft im unteren Teil der Fig. 3 in horizontaler Richtung und stellt die Wortleitung WL (Fig. 1) dar.

Unterhalb des gesamten mäanderförmigen Gateoxidbereiches 6a befindet sich an der Grenzfläche 5a ein $n^+$-dotiertes Halbleitergebiet 17, wobei jedoch vier inselförmige Gebiete 18 bis 21, die strichpunktiert dargestellt sind, aus diesem Halbleitergebiet ausgespart sind. Die Gebiete 18 bis 21 stellen Ansätze des Halbleiterkörpers 5 dar, die in entsprechende Ausnehmungen von 17 hineinragen und sich bis zur Grenzfläche 5a erstrecken. Oberhalb der Streifen 15 und 16 und durch eine isolierende Zwischenschicht von diesen getrennt, befinden sich Leiterbahnen 21a bis 23, vorzugsweise aus Aluminium, die einfach schraffiert dargestellt sind. Im Bereich von Kontaktlöchern 24 bis 26, die in der Gateoxidschicht 6a vorgesehen sind, werden Teile des Halbleitergebiets 17 von den Leiterbahnen 21a bis 23 kontaktiert. In den Bereichen zweier weiterer Kontaktlöcher 27 und 28 werden Teile des Halbleitergebiets 17 von den Enden der Abzweigungen 15a und 15b des Streifens 15 kontaktiert.

0104616

Die Transistoren T1 bis T6 sind in Fig.3 durch Klammern angedeutet. Wie hieraus ersichtlich ist, liegt das Lastelement T4 in der Ebene des polykristallinen Siliziumstreifens im Bereich des Teils 15b, wobei sein Kanalgebiet 11a nur einfach schraffiert dargestellt ist. Das Lastelement T3 liegt in derselben Ebene im Bereich des Teils 15a, wobei sein Kanalgebiet 11b ebenfalls nur einfach schraffiert ist. T1 umfaßt ein Source- und ein Draingebiet links und rechts von Gebiet 19, die Teile des Gebiets 17 sind. T2 weist ein Source- und ein Draingebiet links und rechts vom Gebiet 20 auf, welche ebenfalls Teile des Gebiets 17 sind. T5 umfaßt ein Source- und ein Draingebiet oberhalb und unterhalb des Gebiets 18, die auch Teile von 17 sind. Schließlich weist T6 ein Source- und ein Draingebiet auf, welche oberhalb und unterhalb des Gebiets 21 liegen und ebenfalls Teile des Gebiets 17 sind. Die Leiterbahn 21a entspricht der Bitleitung BL, die Leiterbahn 22 der Bitleitung $\overline{BL}$ und die Leiterbahn 23 dem Schaltungspunkt 2 von Fig. 1. Ein Ansatz des Streifens 15 ist mit dem Anschluß 1 versehen.

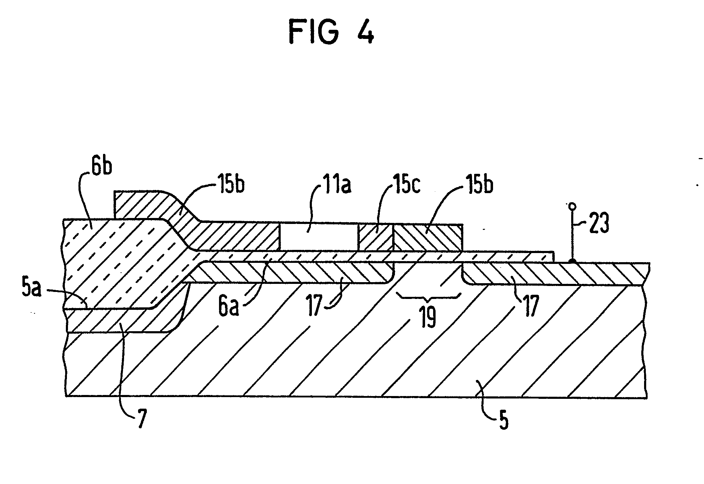

Der Querschnitt der Anordnung nach Fig. 3 entlang der Linie IV-IV ist in Fig. 4 gezeigt. Er läßt das Halbleitergebiet 17 erkennen, das sich unterhalb der Gateoxidschicht 6a befindet. Mit 19 ist das Kanalgebiet des Transistors T1 bezeichnet. Die übrigen Schaltungsteile in Fig. 4 entsprechen den gleichbezeichneten Teilen der Figuren 2 und 3.

Nach Fig. 2 sind die Streifen 15 aus polykristallinem Silizium außerhalb des Kanalgebietes 11 $p^+$-dotiert. Gemäß Fig. 3 ist es jedoch zweckmäßig, daß der links vom Gebiet 11b liegende Teil des Ansatzes 15a und der rechts vom Gebiet 11a liegende Teil des Ansatzes 15b $n^+$-dotiert werden, da diese Ansätze jeweils bei 27 und 28 das

$n^+$-dotierte Halbleitergebiet 17 kontaktieren. In diesem Fall kann ein an das Kanalgebiet 11a angrenzender Teil des Ansatzes 15b, der in Fig. 4 mit 15c bezeichnet ist, mit einer $p^+$-Dotierung versehen sein. Ebenso gilt das für einen an das Kanalgebiet 11b angrenzenden Teil des Ansatzes 15a. Hierdurch wird der p-Kanal-Charakter der Lastelemente T3 und T4 noch stärker hervorgehoben.

Der aus Fig. 3 ersichtliche, besonders einfache Aufbau der Zwei-Kanal-Speicherzelle nach der Erfindung ergibt sich daraus, daß das Draingebiet von T1, das Gategebiet von T4 und das eine Anschlußgebiet von T5 aus einem Teilbereich des $n^+$-dotierten Halbleitergebiets 17 (Fig. 4) bestehen, so daß die in Fig. 1 zwischen diesen Gebieten liegenden Verbindungsleitungen entfallen. Dasselbe gilt für das Draingebiet von T2, das Gategebiet von T3 und das eine Anschlußgebiet von T6. Daher gibt es auch keine Kreuzkopplungen zwischen den vorstehend genannten Verbindungsleitungen. Hinzu kommt noch, daß das Kanalgebiet 19 des Transistors T1 von einem abzweigenden Teil des Ansatzes 15b des polykristallinen Siliziumstreifens überdeckt wird, so daß die in Fig. 1 gezeigte Leitung zwischen dem Schaltungsknoten 4 und dem Gate von T1 entfällt. Analog hierzu wird das Kanalgebiet 20 des Transistors T2 von einem abzweigenden Teil des Ansatzes 15a des polykristallinen Siliziumstreifens 15a überdeckt, so daß die in Fig. 1 dargestellte Leitung zwischen dem Schaltungsknoten 3 und dem Gate von T2 entfällt. Daher können auch keine Kreuzkopplungen zwischen den letztgenannten Leitungen entstehen, die bei einer herkömmlichen Realisierung der Speicherzelle nach Fig. 1 vorhanden wären.

Die Spannungssteuerung der Gategebiete 12 der erfindungsgemäßen Lastelemente T3 und T4 über die Schaltungsknoten 3 und 4 bzw. über die Anschlußgebiete der Auswahltransistoren T5 und T6 erfolgt in der Weise, daß ein auf $V_{DD}$ liegender Knoten, z. B. 3, das Lastelement des anderen Schaltungszweiges, z. B. T4, so hochohmig schaltet, daß praktisch kein Verluststrom fließt. Andererseits ist der Schaltungszweig des betrachteten Knotens, z.B. 3, dadurch hochohmig geschaltet, daß der andere Knoten, z. B. 4, auf Bezugspotential liegt und deshalb der mit seiner Source-Dräinstrecke an dem betrachteten Knoten liegende Schalttransistor, z. B. T1, mit seinem Gate auf Bezugspotential liegt und somit gesperrt ist. Es ergibt sich also eine Spannungssteuerung der Lastelemente wie bei einer CMOS-Realisierung der Speicherzelle, so daß keine statische Verlustleitstung entsteht. Nur beim Umschalten der Speicherzelle von einem Speicherzustand in den anderen wird Leistung verbraucht. Die Spannungssteuerung der Lastelemente bewirkt, daß die Funktion der Speicherzelle auch beim Eindringen von $\alpha$-Teilchen praktisch nicht gestört wird. Da die gesteuerten Lastelemente in der Ebene der polykristallinen Schicht realisert sind, ergeben sich auch keine unerwünschten Thyristoreffekte in der Zellenstruktur. Wegen der Steuerung der Lastelemente über die Gategebiete, die unterhalb der polykristallinen Streifen 15a und 15b liegen, braucht hierfür keine zusätzliche Integrationsfläche aufgewendet zu werden. Auch hieraus ergibt sich eine hohe Packungsdichte bei der Anordnung einer Vielzahl von erfindungsgemäß ausgebildeten Speicherzellen auf einem monolithischen Halbleiterkörper.

Die Ansteuerung der erfindungsgemäßen Speicherzelle über die Wortleitung WL und die Bitleitungen BL und $\overline{BL}$ erfolgt in an sich bekannter Weise. Wird von BL über den leitend geschalteten Transistor T5 eine logische "1" angelegt, so gelangt der Knoten 3 auf das Potential $V_{DD}$, der Knoten 4 auf Bezugspotential. Damit ist die "1" gespeichert.

0104616

-9- VPA 82 P 1897 E

Das Auslesen des gespeicherten Signals erfolgt bei leitend geschalteten Auswahltransistoren T5 und T6 über herkömmliche Leseverstärker. Hierzu wird auf das Buch von Luecke, Mize und Carr, "Semiconductor Memory Design und Application", McGraw-Hill Kogykusha Ltd., Tokyo, 1973, Seiten 116 bis 119, verwiesen.

8 Patentansprüche
4 Figuren

## Patentansprüche

1. Statische Speicherzelle in Zwei-Kanal-Technik, bei der zwei Schalttransistoren eines ersten Kanaltyps, die auf einem dotierten Halbleiterkörper angeordnet sind, über jeweils ein Lastelement des zweiten Kanaltyps an eine Versorgungsspannungsquelle geschaltet sind und mit ihren Sourceanschlüssen auf Bezugspotential liegen, bei der die Drainanschlüsse der Schalttransistoren Schaltungsknoten bilden, von denen wenigstens einer über einen an einer Wortleitung liegenden Auswahltransistor mit einer Bitleitung verbunden ist, und bei der die Schaltungsknoten mit dem Gate des jweils anderen Schalttransistors und dem Gate des zu diesem in Serie liegenden Lastelements verbunden sind, d a d u r c h   g e k e n n z e i c h - n e t ,   daß jedes der Lastelemente (T3, T4) aus stark dotierten Abschnitten (9, 10) einer durch eine isolierende Schicht von der Grenzfläche des Halbleiterkörpers getrennten Schicht (8) aus polykristallinem Silizium bestehen, die Source- und Draingebiete darstellen, sowie aus einem zwischen diesen Abschnitten liegenden, schwach dotierten oder undotierten Teil (11) der polykristallinen Schicht, der ein Kanalgebiet bildet, und aus einem sich bis zur Grenzfläche (5a) des Halbleiterkörpers (5) erstreckenden, mit einem hohen Dotierungsgrad entgegengesetzt zu der Grunddotierung des Halbleiterkörpers (5) dotierten Halbleitergebiet (12), das als ein Gategebiet dient.

2. Statische Speicherzelle nach Anspruch 1, d a - d u r c h   g e k e n n z e i c h n e t ,   daß das Gategebiet des einen Lastelements (T4) zusammen mit dem Draingebiet des zu dem anderen Lastelement (T3) in Serie liegenden Schalttransistors (T1) einem gemeinsamen, sich bis zur Grenzfläche (5a) des Halbleiterkörpers (5) erstreckenden Halbleitergebiet (17) angehört.

0104616

3. Statische Speicherzelle nach Anspruch 1 oder 2,   d a -
d u r c h   g e k e n n z e i c h n e t ,   daß der das
Sourcegebiet eines Lastelements (T4) darstellende Abschnitt
der polykristallinen Schicht (15) entsprechend dem Kanaltyp dieses Transistors dotiert ist, während der das
Draingebiet des Lastelements (T4) darstellende Abschnitt
(15b) entsprechend dem anderen Kanaltyp dotiert ist und
durch ein in der isolierenden Schicht (6a) vorgesehenes
Kontaktloch (28) das in den Halbleiterkörper (5) eingefügte Draingebiet des in Serie zu dem Lastelement (T4)
liegenden Schalttransistors (T2) kontaktiert.

4. Statische Speicherzelle nach Anspruch 3,   d a -
d u r c h   g e k e n n z e i c h n e t ,   daß der das
Draingebiet des Lastelements (T3) darstellende Abschnitt
(15a) an seinem dem Kanalgebiet (11b) dieses Lastelements
(T3) zugekehrten Ende mit einer starken, dem Kanaltyp
entsprechenden Dotierung (15c) versehen ist (Fig. 4).

5. Statische Speicherzelle nach einem der Ansprüche 1 bis
4,   d a d u r c h   g e k e n n z e i c h n e t .,
daß das Kanalgebiet (19) eines Schalttransistors (T1) von
einem als Gate dienenden ansatzartigen Teil desjenigen
Abschnitts der polykristallinen Schicht (15b), die das
Draingebiet des zu dem anderen Schalttransistor (T2)
in Serie liegenden Lastelements (T4) darstellt, überdeckt
wird.

6. Statische Speicherzelle nach einem der Ansprüche 1 bis
5,   d a d u r c h   g e k e n n z e i c h n e t ,
daß das erste Anschlußgebiet eines Auswahltransistors (T5),
dessen zweites Anschlußgebiet mit einer Bitleitung (21a)
verbunden ist, mit dem Gategebiet des einen Lastelements
(T4) und mit dem Draingebiet des zu dem anderen Lastelement (T3) in Serie liegenden Schalttransistors (T1) Teile
eines gemeinsamen Halbleitergebiets (17) bilden.

7. Statische Speicherzelle nach einem der Ansprüche 1 bis 6, d a d u r c h   g e k e n n z e i c h n e t ,   daß das Gate eines Auswahltransistors (T5) aus einem Abschnitt einer stark dotierten, polykristallinen Siliziumschicht besteht, die als Wortleitung (WL) dient.

8. Statische Speicherzelle nach einem der Ansprüche 1 bis 7, d a d u r c h   g e k e n n z e i c h n e t ,   daß die Lastelemente (T3, T4), die Gates der Schalttransistoren (T1, T2) und die Wortleitung (WL) aus Teilen einer einzigen auf einer Grenzfläche des Halbleiterkörpers aufgebrachten und durch eine isolierende Schicht von dieser getrennten, polykristallinen Siliziumschicht bestehen.

FIG 1

FIG 2

2/3

FIG 3

FIG 4